# EUROPEAN PATENT SPECIFICATION

(11) **EP 1 644 953 B1**
(45) Date of publication and mention of the grant of the patent: **16.06.2010**
(21) Application number: 04777756.0
(22) Date of filing: 08.07.2004
(51) Int. Cl.: H01J 9/02

(54) **FILLING VIAS WITH THICK FILM PASTE USING CONTACT PRINTING**
FÜLLEN VON KONTAKTLÖCHERN MIT DICKFILMPASTE DURCH VERWENDUNG VON KONTAKTDRUCK
REMPLISSAGE DE TROUS D'INTERCONNEXION AVEC UNE PATE A COUCHE EPAISSE PAR IMPRESSION PAR CONTACT

(30) Priority: 08.07.2003 US 485419 P
(43) Date of publication of application: 12.04.2006
(73) Proprietor: E.I. DU PONT DE NEMOURS AND COMPANY, Wilmington, DE 19898 (US)
(72) Inventor: CHENG, Lap-Tak, Andrew, Newark, DE 19711 (US); BEIKMOHAMADI, Allan, Cary, NC 27513 (US)
(74) Representative: Thomson, James B.
(86) International application number: PCT/US2004/021862
(87) International publication number: WO 2005/020295

(56) References cited:
- EP-A- 1 020 888
- WO-A-01/99146
- US-A- 5 681 387
- US-A- 6 074 893
- US-B1- 6 579 790
- PATENT ABSTRACTS OF JAPAN vol. 018, no. 311 (E-1561), 14 June 1994 (1994-06-14) & JP 06 069258 A (NEC CORP), 11 March 1994 (1994-03-11)
- PATENT ABSTRACTS OF JAPAN vol. 1999, no. 05, 31 May 1999 (1999-05-31) & JP 11 042762 A (FUJITSU LTD), 16 February 1999 (1999-02-16)

## Description

### FIELD OF THE INVENTION

The present invention relates to a process for filling vias in an electronic structure with thick film paste. The invention is particularly useful in fabrication of electron field emission triode arrays where the vias are of fine dimension (< 100 µm in diameter) and the electron emitter thick film paste, which may contain carbon nanotubes, is of high value.

### TECHNICAL BACKGROUND

Bouchard et al (WO 01/99146) describe a field emitter thick film paste composition, a process of application of said thick film paste by conventional screen printing and photoimaging, as well as a process for improving the field emitter.

The use of conventional screen printing however presents several disadvantages. Firstly, since the thick film paste must be squeezed through the fine mesh of a screen, the shadow marks of the screen mesh are always present in the printed paste film. These mesh marks can lead to incomplete and uneven filling of vias or slots of fine dimensions. Secondly, the screen printed film has a finite thickness and will invariably over fill the vias or slots on the substrate. Thirdly, since the vias or slots areas on the substrate typically represents only 2 to 10 % of the total printed area, a large excess of paste is used with conventional screen printing. This excess amount of paste not only leads to significantly higher material cost, but also results in longer drying time and greater difficulty in removing all excess paste from unwanted area.

The present invention, provides for an improved method to fill the vias or slots on a substrate. The contact printing method departs from the conventional screen printing method by eliminating the use of an external screen and by bringing a coating edge into direct contact with the substrate. A coating edge is a straight edge used to spread a deposit of thick film paste. The coating edge may be a blade or rod made of rigid or elastomeric material. The coating edge may be equipped with openings in the edge itself through which a thick film paste can be metered onto the substrate or the thick film may be metered from a separate thick film container located in front of the coating edge.

### SUMMARY OF THE INVENTION

The present invention relates to a process according to claim 1.

In the claimed process, the thick film paste may be metered through openings equipped on a coating edge or from a container located in front of the coating edge.

The thick film paste may comprise an acicular emitting substance.

The present invention also may include the acicular emitting substance as carbon nanotubes.

In one embodiment, the coating edge comprises one or more wings on either end, which are in contact with the top surface. The wings are perpendicular to the coating edge and serve the purpose of preventing paste run-off. The wing may be formed from any suitable material including such materials as metals, plastics and like material.

In another embodiment the thick film paste may be printed where a coating edge is parallel rather than orthogonal to the via side (edge) of greatest length. This results in more deposition of material in the vias.

The present invention also describes an electronic device comprising a substrate coated with thick film paste deposited by the processes outlined above.

### BRIEF DESCRIPTION OF THE DRAWINGS

Figure 1 shows a device structure with a patterned dielectric and conductive material.
Figure 2 shows a device structure after removal of photoresist from the interior of the vias.
Figure 3 shows a device structure coated with a buffer layer.
Figure 4 shows the deposition of a small bead the emitter paste and positioning of a coating edge in preparation for contact printing.
Figure 5 shows the structure of the printed thick film paste in the vias by contact printing.
Figure 6 shows the optional repeated printing with the coating edge moving in the reverse direction.
Figure 7 shows the back UV irradiation of the thick film paste in the vias.
Figure 8 shows the spray development and rinsing of the thick film paste and buffer.
Figure 9 shows the structure of the device after removal of the photoresist.
Figure 10 shows the structure of the device after firing of the thick film paste.
Figure 11 illustrates the optional activation step for thick film pastes containing acicular emitting substances.
Figure 12 shows the structure and images of an actual device with patterned photoresist containing arrays of 20 µm vias and a buffer layer.
Figure 13 shows the surface images of an actual device after contact printing and drying of emitter paste.
Figure 14 shows the surface images of an actual device after paste development.
Figure 15 shows the emitter paste dots after clean removal of the photo-resist.
Figure 16 shows the surface images of emitter dots after the adhesive tape activation process.
Figure 17 shows the surface images of the activation tape showing emitter transfer to tape.
Figure 18 shows the electron field emission illumination of an anode by emitter paste dot arrays deposited with the contact printing process.

### DETAILED DESCRIPTION

The present invention is a process for the fabrication of electronic devices comprising substrates coated with patterned thick film pastes. The present invention is also a device made by the process of the invention. One example of such a device is an electron field emission triode array for use in visual displays where the thick film paste comprises an acicular emitting substance, such as a carbon nanotube, to enhance the electron field emission properties of the thick film paste. An acicular emitting substance is a material with a high length to width aspect ratio, sharp radius of curvature at the end, and electrical conductivity to promote field emission of electrons under an applied electrical potential.

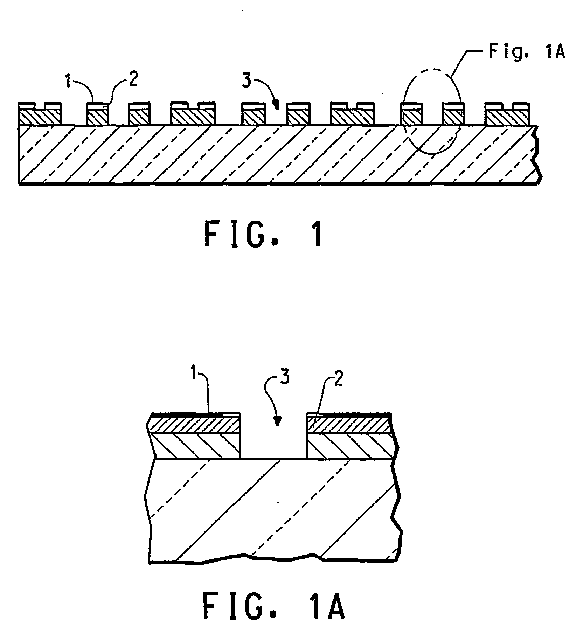

In the present process, the structure is fabricated on a transparent substrate, such as glass, which is coated with a conductive film such as indium-tin oxide. A dielectric layer is then deposited on the coated substrate and patterned by techniques such as photolithography or wet etching. In certain designs, vias or slots are fabricated through the dielectric deposit extending to the coated substrate. A via is a hole in a layer at the surface of a multi-layer electronic device. The hole may be any shape. These vias or slots may be intended to house the electron emitter thick film materials. A conductive gate electrode which may be chromium is then deposited over the dielectric leaving the via clear. The chromium gate electrode may be deposited by evaporation or sputtering techniques followed by lithographic and etching steps. An example of the structure of the device at this point in the fabrication process is shown in Figure 1 where Cr gate 1, dialectric 2 and via 3 are shown. In other designs, no via or slots are produced on the dielectric layer. Instead, fine patterns of emitter thick film paste are deposited in tight tolerance to the electrode structures.

A substrate with built-in vias or slots is ready for via filling with emitter thick film paste by using the contact printing process as disclosed in the present invention. However, an unprotected substrate is vulnerable to damage or scratches by the coating edge. Therefore, it is recommended that a photoresist layer be applied to protect the substrate surface. For a substrate without built-in via or slots, a photoresist layer can be used to define the placement of emitter thick film paste by precise patterning of vias or slots in the photoresist. In addition to defining the placement of emitter paste, a photoresist layer also serves as a lift-off layer to insure the clean development of the thick film paste.

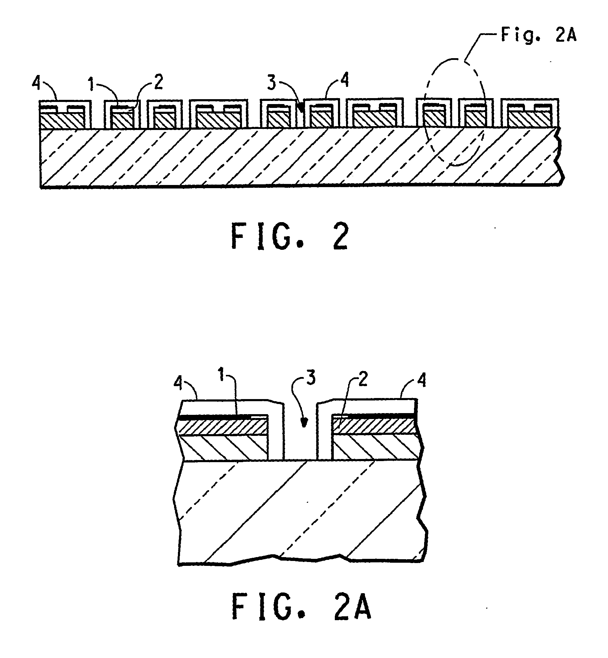

The photoresist may be of positive or negative type and is typically deposited by spin coating or slot die coating. For positive photoresist such as the DNQ/novalac or the chemically amplified resists, vias or slots can be created in the photoresist layer by masked UV exposure of the via or slot area followed by development. The via or slot irradiated areas of the photoresist become soluble in mild base developer such as 1 % KOH or 2.6% tetramethyl ammonium aqueous solutions and may be removed from the substrate. The structure of the device after removal of the photoresist from the vias or slots is shown in Figure 2.

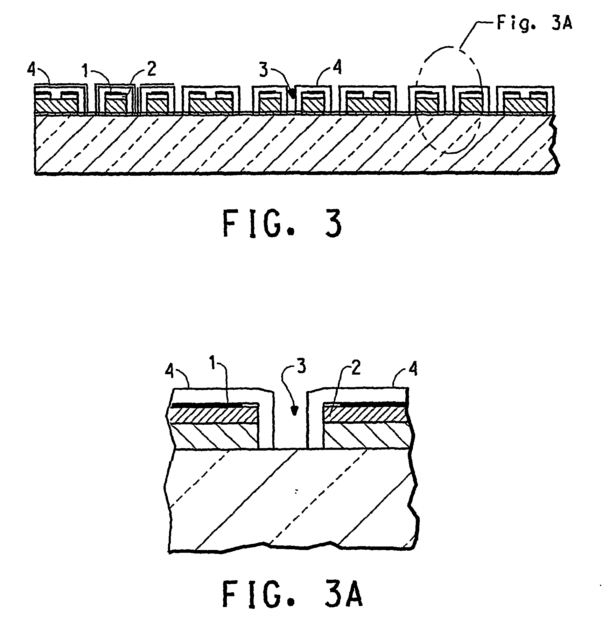

It has been observed that some photoresists are not compatible with the solvents used in some formulations of thick film pastes. The solvent in the thick film may attack the photoresist which can lead to poor paste deposition. It has been found that use of a buffer layer of materials, which are inert to the solvent used in the thick film paste formulation, can protect the photoresist and insure accurate paste deposition. Polyvinyl alcohol (PVA) is an example of an appropriate buffer layer. PVA may be applied to the device structure by spin coating or slot die coating. The use of the buffer layer 4 is however optional depending of the chemical compatibility between the thick film paste and photoresist. The structure of the device at this point in the processing is shown in Figure 3.

The next step in the process of the present invention is the deposition of the thick film paste. The thick film paste typically comprises solvent, organic, and inorganic ingredients. The solvent may typically be high boiling liquid such as butyl carbitol, butyl carbitol acetate, dibutyl carbitol, dibutyl phthalate, texanol, and β-terpineol. The organic ingredients include binder polymer, photo-active monomers, initiators, dispersants, and/or other rheology modifiers. The inorganic ingredients include glass frit, inorganic powders and /or metallic powders. A special case of thick film paste are pastes comprising acicular emitting materials such as carbon nanotubes to enhance the electron field emission of the paste.

To apply the paste to the substrate, conventional screen printing is commonly used. In conventional screen printing, a steel or polymeric screen consisting of fine mesh stretched under high tension is placed on top of the substrate. The through opening of the screen mesh is first patterned with a polymeric emulsion to define the printing area. For photoimagable thick film paste, an un-patterned flood print of the thick film paste is typically used to cover nearly the entire substrate surface. To prepare for screen printing, an excess amount of thick film paste is first spread over the screen. A coating edge, typically a blade like device fabricated from elastomer of varying durometer is brought into contact with the screen mesh. The blade is then pushed across the screen over the thick film paste thus squeezing the thick film paste through the open mesh area of the screen and depositing the paste on the substrate. In conventional screen printing, the coating edge never comes into contact with the substrate itself.

The use of conventional screen printing however presents several disadvantages. First, since the thick film paste must be squeezed through the fine mesh of a screen, the shadow marks of the screen mesh may be present in the printed paste film. These mesh marks can lead to incomplete and uneven filling of the via or slots. Secondly, the screen printed film has a finite thickness and will invariably over fill the via or slots on the substrate. Thirdly, since the via or slots area on the substrate typically represents only 2 to 10 % of the total printed area, a large excess of paste is used with conventional screen printing. This excess amount of paste not only leads to significantly higher material costs, but also results in longer drying time and greater difficulty in removing all excess paste from unwanted area of the substrate.

The present invention provides for an improved process, called contact printing, to fill the vias or slots on the substrate. The contact printing process departs from the conventional screen printing method by eliminating the use of an external screen and by bringing a coating edge similar to that used in conventional screen printing into direct contact with the substrate surface. A coating edge is a straight edge used to spread a deposit of thick film paste. The coating edge may be a blade or rod made of rigid or elastomeric material. The coating edge may be equipped with openings through which a thick film paste can be metered onto the substrate. The thick film may also be metered onto the substrate at a location in front of the coating edge from a separate thick film container.

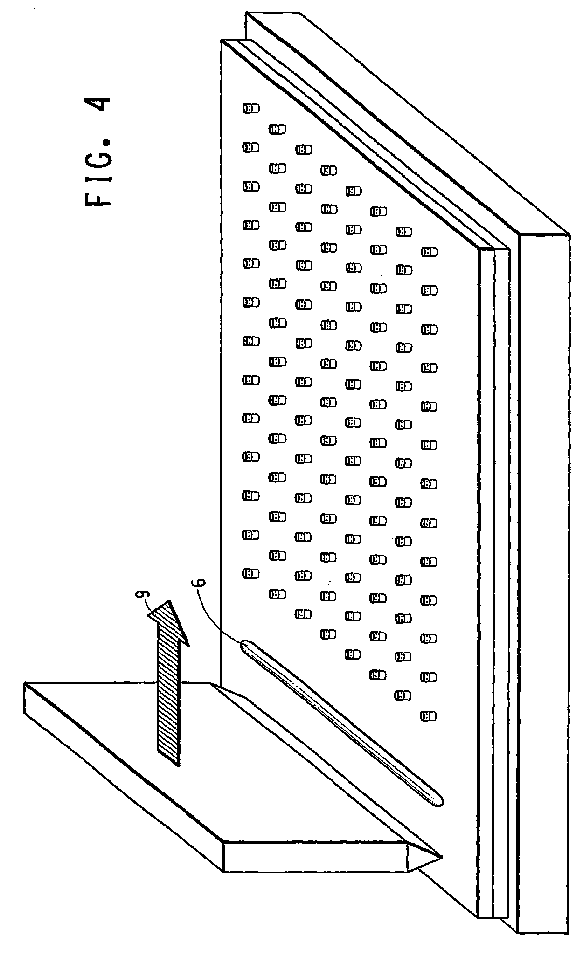

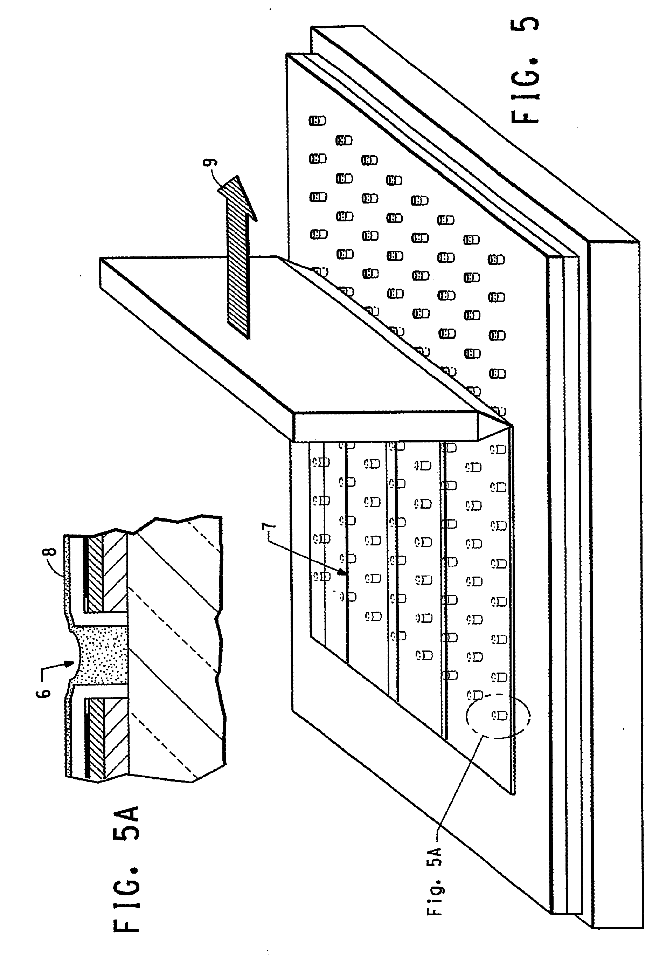

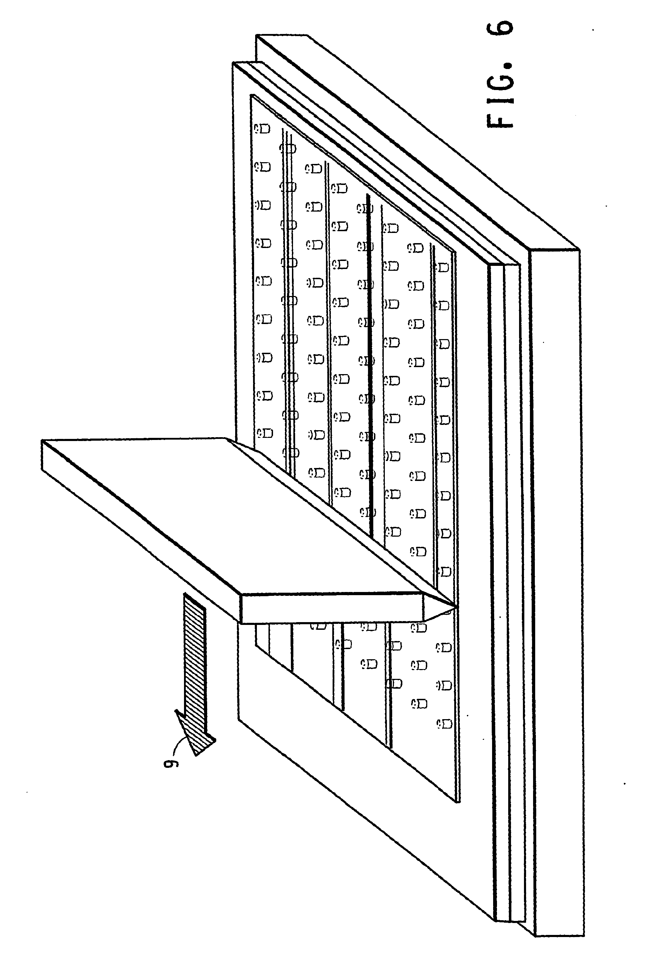

In one embodiment of the present invention, a small bead of paste is first applied on the leading edge of the substrate. The paste can be conveniently applied using a metering pump connecting to a syringe filled with thick film paste. A bead of paste can be precisely deposited as the syringe traverses across the leading edge of the substrate. For large substrates, it may be necessary to meter out multiple beads of paste at distributed locations along the substrate or equip a coating edge with openings through which thick film paste can be continuously metered on the substrate. The coating edge, a blade or rod like device, which can be similar to the elastomeric blade used in conventional screen printing, is then brought into contact with the substrate at a location just advance of the paste bead. A constant pressure is used to maintain contact between the said device and the substrate surface while it is advanced across the substrate surface. As the device is pulled across the bead of paste, it picks up the paste and pushes it into the via or slot openings on the substrate. Unlike in conventional screen printing, only a very thin trace of paste is left on top of the substrate, photoresist, or buffer layer surface in the form of streaks. Except for the paste via fills, nearly all of the paste is pushed ahead of the coating edge and off the contact surface. The edge geometry and durometer, applied pressure, as well as printing speed all have influence on the depth of via fills and the quantity of residual paste deposit left on top of the contact surface. Using a blade of 80 Shore A durometer, pressure of 30 psi (1 psi = 6,8948.10³ Pascal), and printing speed of 0.5 inch/sec (1 inch = 2,54 cm), complete filling of 20 µm diameter and 10 µm depth vias is obtained. However, the contact printing process may lead to incomplete filling of vias for via dimensions greater than 100 microns orthogonal to the direction of motion of the coating edge. Optionally, the coating edge can be traversed in the reverse direction for a second pass in order to further fill the via with thick film paste. These steps in the device fabrication are illustrated in Figures 4, 5, and 6.

In another embodiment of the present invention, the thick film paste can first be spread over the entire surface substrate. This can be done by either conventional screen printing or slot die coating. A coating edge is then contacted and pulled across the said surface to fill the vias and slots with paste and to remove all excess paste from the contact surface. This alternative clearly involves one additional step and is therefore not preferred.

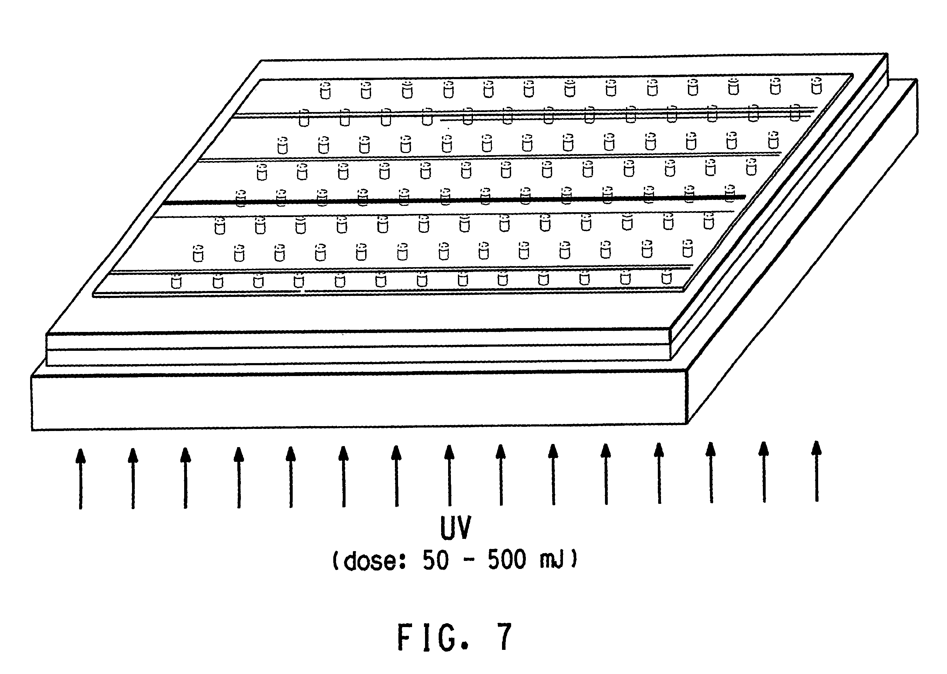

The deposited paste is then dried at conditions to remove the solvent. The drying is typically carried out in a convection furnace or with heating lamps at temperature ranging from 35-100°C for 15 to 30 minutes. After drying, the paste in the via fill areas is exposed to UV radiation through either an in situ or an external photomask. In certain situations as depicted in Figure 7, the paste filled in the vias can be conveniently exposed to a proper UV light dose (50 to 100 mJ/cm²) through the transparent substrate. The residual paste deposited on top of the contact surface is not irradiated by this procedure due to the UV absorbance/reflectivity of the electrode coating, dielectric material, and/or photoresist. The thick film paste is formulated with photopolymers such that the paste becomes insoluble in many solvents upon irradiation.

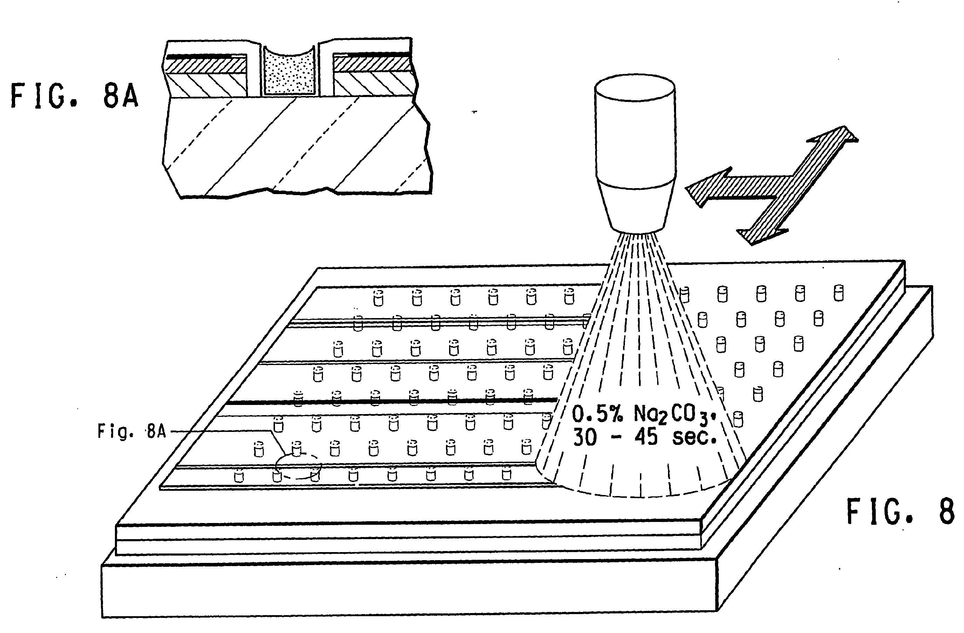

After irradiation, the structure is developed by spraying and rinsing with an appropriate developing solution, which removes the un-irradiated thick film paste. For paste containing acidic binder polymer, 0.5% aqueous solution of sodium carbonate may be used. With many paste formulations, a spray time of 30 to 45 seconds is required. If a buffer layer was used to isolate the photoresist from the thick film paste, it may also be removed during this spray and rinse step. Figure 8 shows the spray and rinsing step of the process.

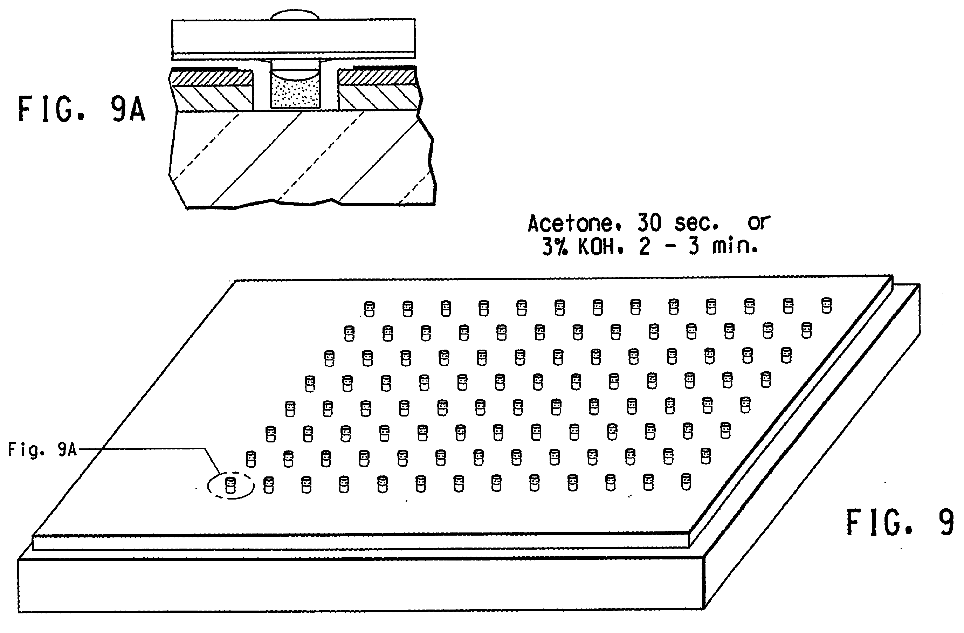

The next step in the process is removal of the photoresist. The photoresist may be removed by dipping the substrate in an appropriate solvent. For DNQ/novalac photoresist, this may be acetone with a 30 seconds exposure or 3% aqueous potassium hydroxide with an exposure of 2 to 3 minutes. The structure of the device after removal of the photoresist is shown in Figure 9.

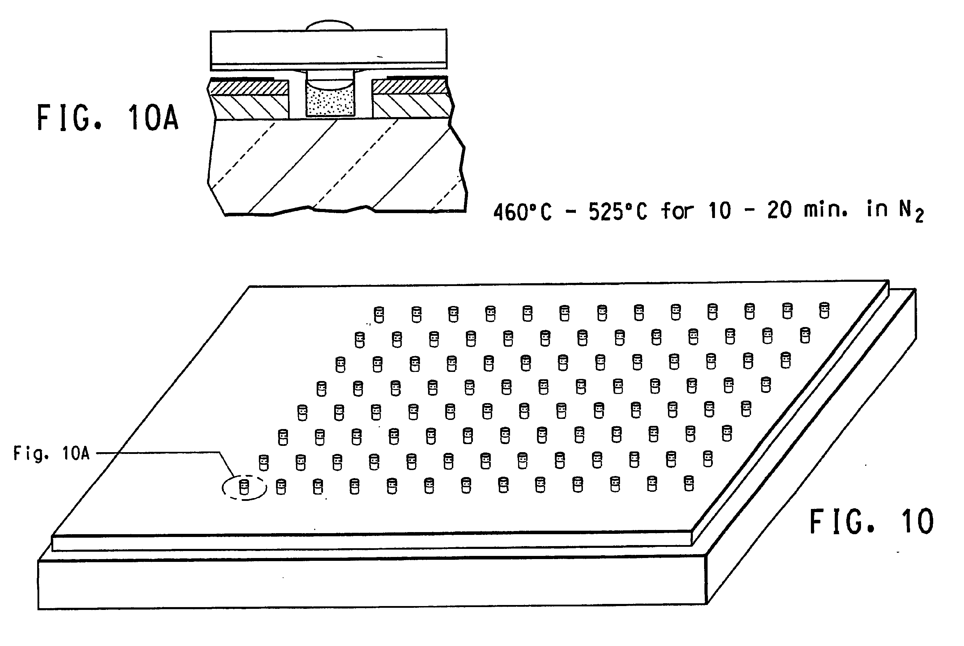

The next step in the process is firing of the thick film paste. This step burns off organic binders and sinters the inorganic phase of the thick film paste. The inorganic phase may contain glass frit, metal powders, and carbon materials. For carbon nanotube containing paste, firing conditions of 460°C to 525°C for 10 to 20 minutes in nitrogen may be used. Figure 10 illustrates this process step.

In one embodiment the thick film paste is printed where a coating edge is parallel rather than orthogonal to the via side (edge) of greatest length. This results in more deposition of material in the vias.

The coating edge may have one or more "wings" on either end, which are in contact with the top surface. The wings are perpendicular to the coating edge and serve to prevent paste run-off.

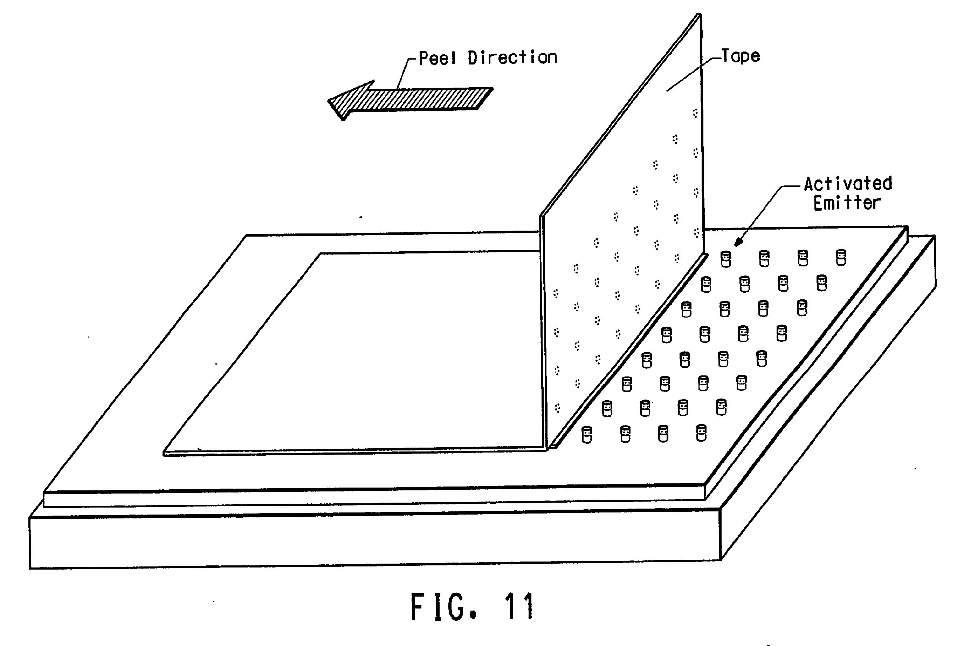

If the device is a carbon nanotube thick film paste electron field emitter, it may be necessary to activate the emitter deposit by an adhesive contact method. This is done by laminating a sheet of polymer over the device. The polymer adheres to the surface of the thick film paste deposit. The polymer sheet is then peeled off of the device. This delamination of the polymer sheet fractures and rearranges the surface of the thick film paste field emitter such as to enhance the field emission. This step in the process is shown in Figure 11.

### Examples

The following examples illustrate the disadvantage of conventional screen printing filling of via as well as the effectiveness of using contact printing to fill via as provided by the present invention.

### Example 1

This example demonstrates the disadvantages of using conventional screen printing to fill fine dimension vias with a thick film paste as part of a process to fabricate an electron field emission device.

A glass substrate coated with an in-situ chromium photomask was prepared by first sputtering a layer of Cr of about 2000 A (1 angstrom = 0,1 nm) on the glass substrate. The Cr layer was patterned with arrays of 20 µm circles where the Cr coating was etched out. A novalac type photoresist, AZ4620 obtained from Clariant Cooperation of Sulzbach am Taunus, Germany, was spin coated on the Cr coated side of the glass substrate. A spinning speed of 1000 rpm and a spinning time of 45 seconds were used. The novalac polymer film was dried on a 95°C hot plate for 10 minutes. A 12 µm thick novalac polymer film was obtained after drying. The photoresist was exposed to UV (350-450 nm) radiation through the in-situ Cr photomask from the back side of the substrate. A UV dose of 400 mJ/cm² was used. The photoresist was developed in AZA21K developer solution (contains 1% potassium hydroxide) also obtained from Clariant for 90 seconds. Post development, the substrate was baked on a 120 °C hot plate for 3 minutes.

An aqueous solution of polyvinylalchol (PVA) was prepared for use as a buffer layer. Fully hydrolyzed (99%) grade of PVA with molecular weight of 130,000 was selected for its high resistant to organic solvents as well as cold water dissolution. The fully hydrolyzed PVA solution is prepared by dissolving 4 grams of polymer in 200 ml of hot water (> 90 C). The solution was allowed to cool to room temperature. A 200 ml mixture of isopropyl alcohol (IPA), introduced to improve wetting of the photoresist surface, and water was separately prepared by mixing 100 ml of each. The mixture was gradually stirred into the PVA solution to complete 400 ml of buffer layer solution that contains about 1 wt% of PVA.

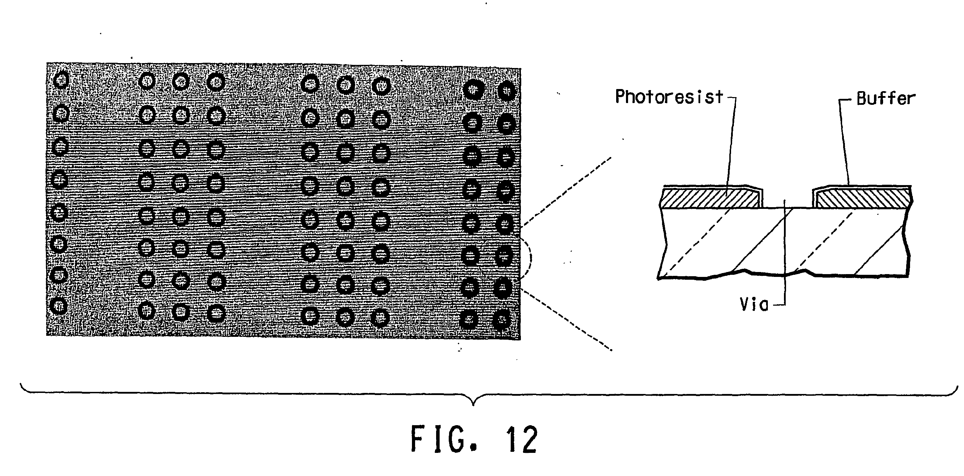

A single layer of the PVA buffer was spin coated on the substrate previously patterned with novalac photoresist. A spinning speed of 1000 rpm and a spinning time of 45 seconds were used. The buffer layer was spun dry at room temperature resulting in a dry thickness of 0.5 µm. Figure 12 shows the patterned photoresist containing arrays of 20 µm vias coated with a buffer layer.

A photoimagable thick film pastes that contains binder polymers, photo-initiator, monomers, silver particles, glass frit, and carbon nanotubes (CNT) was prepared using β-terpineol as the paste solvent. This CNT paste is effective in the fabrication of both diode and triode electron field emission devices. Using conventional screen printing process, a blanket film of the CNT paste was deposited on the substrate over coating the patterned photoresist. A C400 mesh screen was used for printing. The CNT paste film was dried in a force air convection oven at 50°C for 30 minute. The thickness of the dried CNT paste film was found to be up to 8 µm thick over the buffered photoresist. Close examination of the dried paste film revealed the presence of mesh marks and rheology induced orange peel defects. These defects lead to incomplete filling of vias in the photoresist. The total weight of the dried emitter film was determined to be 0.52 g for a 25 inch² coverage.

The thick film paste film was exposed to UV radiation through the built-in photomask from the back of the substrate with an exposure dose of about 300 mJ/ cm². The exposed CNT paste film was sprayed with 0.5 % NaCO₃ aqueous solution for 1 minute during which the CNT paste film was washed away from regions where the paste was not irradiated. Where the paste was exposed to UV radiation, arrays of CNT paste dots remain. The weight of the emitter paste via fills was determined to be 0.03 g. Therefore, over 94 % of the screen printed emitter paste was washed away during development thus illustrating the highly inefficient use of CNT emitter paste with conventional screen printing.

### Example 2

This example describes the contact printing process and illustrates the benefits of using contact printing for filling vias with a photoimagable thick film paste containing carbon nanotubes.

As in Example 1, a glass substrate coated with an in-situ Cr photomask patterned with an array of open circles of 20 µm was prepared. A novalac type photoresist, AZ4620 obtained from the Clariant Cooperation, was spin coated on the Cr coated side of the glass substrate. A spinning speed of 1000 rpm and a spinning time of 45 seconds were used. The novalac polymer film was dried on a 95°C hot plate for 10 minutes. A 12 µm thick novalac polymer film was obtained after drying. The photoresist was exposed to UV (350-450 nm) radiation through the in-situ Cr photomask from the back of the substrate. A UV dose of 400 mJ/cm² was used. The photoresist was developed in AZA21 K developer solution also obtained from Clariant for 45 seconds. Post development, the substrate was baked on a 120°C hot plate for 3 minutes. As in example 1, a single layer of PVA polymer was spin coated over the photoresist as buffer layer. Figure 12 again shows the patterned photoresist containing arrays of 20 µm vias and coated with a buffer layer.

A quantity of photoimagable CNT thick film paste, as used in Example 1, is filled into a syringe equipped with a 2 mm opening needle. A bead of paste, about 2 mm thick, is metered along the leading edge of the substrate. The substrate is mounted on the substrate holder of a conventional screen printer. A conventional screen printing blade with Shore A hardness of 80 is brought into direct contact with the photoresist-coated substrate at a location a few mm ahead of the paste bead. A constant pressure of 30 psi is used to maintain contact between the blade and the substrate surface while the blade is advanced across the substrate surface at a speed of 0.5 inch/sec. As the blade is pulled across the bead of paste, it picks up the paste and pushes the paste into the vias on the substrate. Unlike in conventional screen printing, only a very thin trace of paste is left on the substrate surface in the form of streaks. Except for the via fills, most of the paste is pushed ahead of the blade and eventually off the substrate surface.

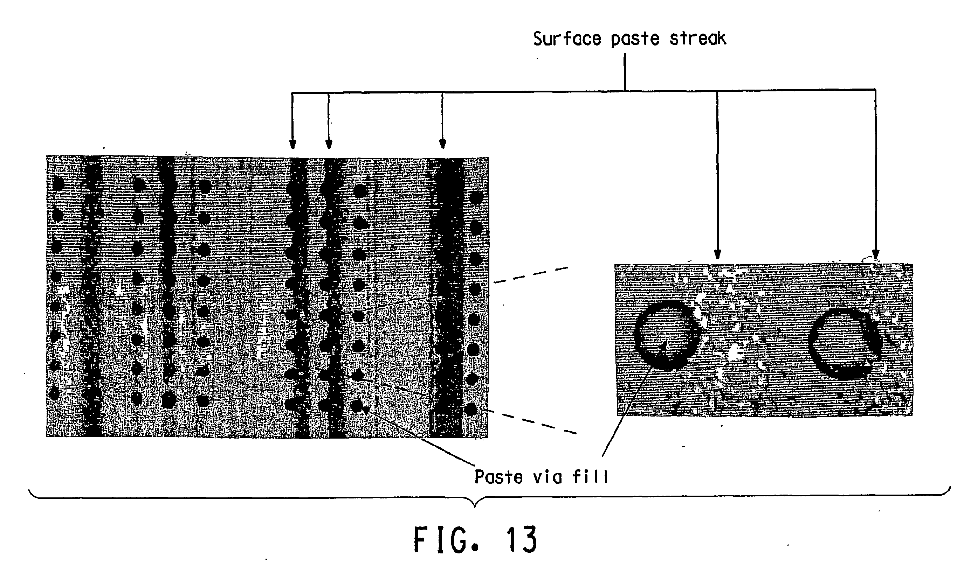

The CNT paste film was dried in a force air convection oven at 50°C for 10 minutes. Due to the lower paste volume, a much shorter drying time can be used thus illustrating one of the benefits of the contact printing process. The thickness of the dried CNT paste film was found to be only 1-2 µm at streak area over the photoresist and 5-6 µm within the vias. This illustrated the benefit of not over filling the vias by contact printing. Close examination of the dried paste film showed good paste filling of all vias illustrating yet another benefit. The total weight of the dried emitter film was determined to be only 0.04 g for a 25 inch² coverage. Therefore, using contact printing was demonstrated to greatly reduces the use of emitter paste by more than an order of magnitude. Figure 13 shows the surface images an actual device at this point in processing.

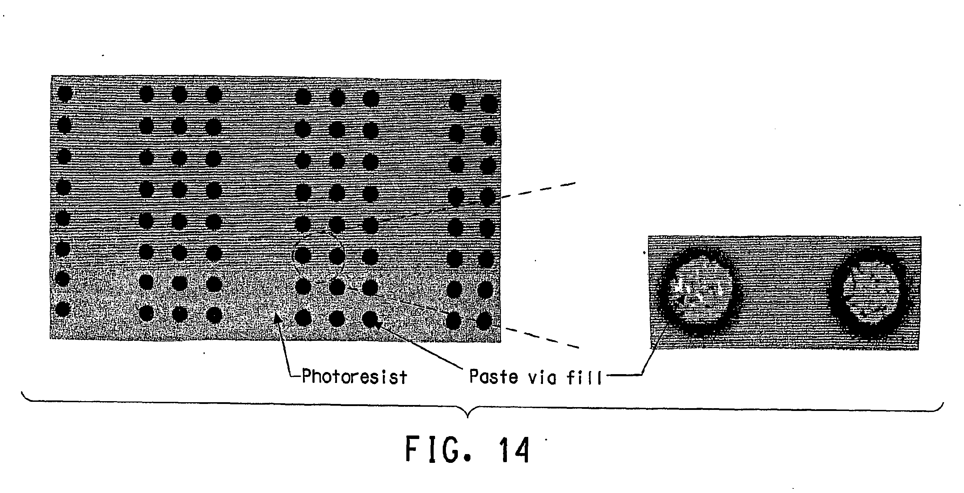

The thick film paste film was exposed to UV radiation through the built-in photomask from the back of the substrate with an exposure dose of about 300 mJ/cm². The exposed CNT paste film was sprayed with 0.5% NaCO₃ aqueous solution for 1 minute during which the CNT paste film was washed away from regions where the paste was not irradiated. Where the paste was exposed to UV radiation, arrays of CNT paste dots remain. The weight of the emitter paste via fills was determined to be 0.02 g. Figure 14 shows the surface images of an actual device after paste development.

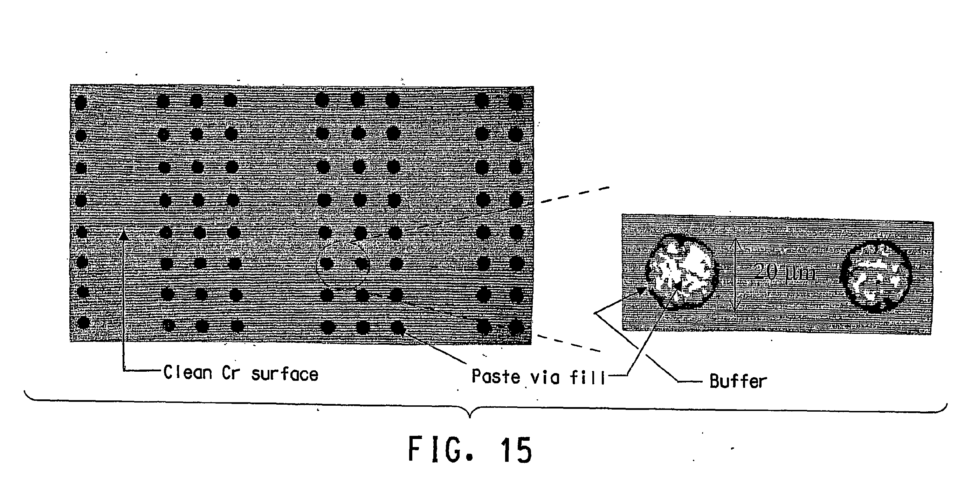

To prepare the substrate for photoresist lift-off, the substrate was further rinsed in room temperature water for 1-2 minutes to remove the buffer layer from regions that is not covered by the CNT paste. The photoresist was subsequently removed by immersion in a 3% aqueous solution of KOH for 2 minutes. Figure 15 shows the CNT emitter paste dots after clean removal of the photo-resist.

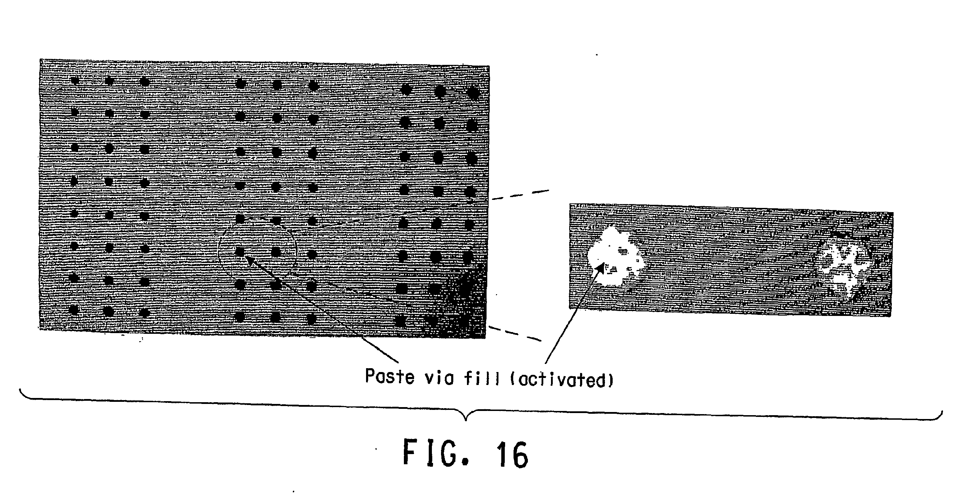

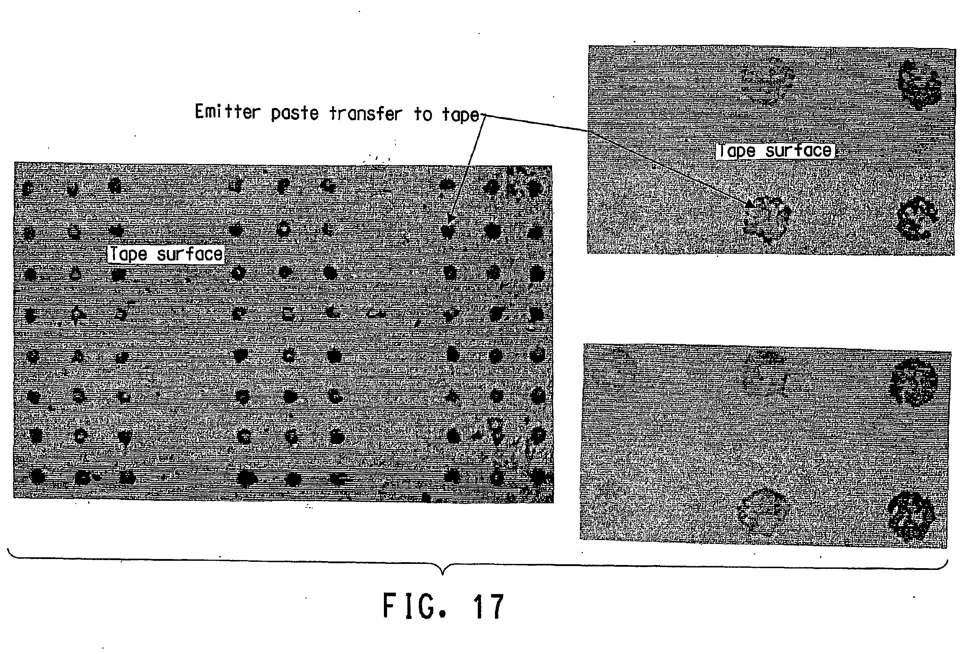

The substrate was fired in a nine-zone belt furnace set at a maximum temperature of 465°C with a dwell time of 20 minutes at the maximum temperature zone. The fired substrate was activated by the adhesive activation method using a tape coated with pressure sensitive adhesive. The surface images of an actual device and tape after activation is shown as Figure 16 and 17.

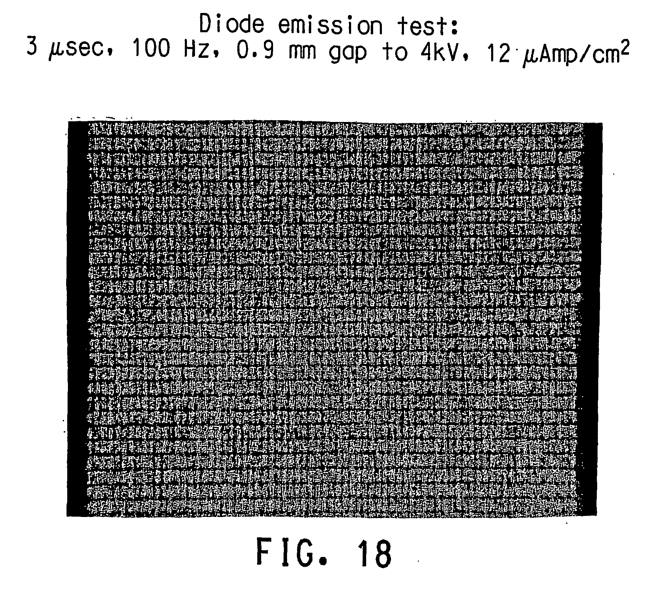

The substrate, deposited with arrays of CNT paste dots, was used as the cathode in an electron field emission diode device consisting of a cathode and an anode. The anode consisted of an ITO coated glass plate with P13 phosphor particle deposited on the ITO surface. The cathode and anode were separated by 0.9 mm thick glass spacers. The diode assembly, with the cathode connected to a high voltage pulsed power supply and the anode connected to ground through an electrometer, was then placed into a vacuum chamber and evacuate to a background pressure of below 1xE-6 torr (1 torr = 133,322 Pascal). High current electron field emission was observed when the cathode was energized by a high voltage pulse train consisting of negative polarity voltage pulses at 100 Hz and duration of 3 µsec. An average anode field emission current density of 12 µAmp/cm² was measured at an applied voltage of 4 kV. Figure 18 shows the electron field emission illumination of the anode by the CNT paste dot arrays deposited with the contact printing process.

## Claims

1. A process comprising:
a) coating a photoresist on a first side of a transparent substrate;
b) patterning vias (3) in said photoresist;
c) applying a deposit of thick film paste on said photoresist, by means of a coating edge;
d) spreading the deposit of thick film paste across the surface of said photoresist with a coating edge in direct contact with the top surface of said photoresist such that the thick film paste fills said vias; and
e) irradiating the thick film paste through the transparent substrate with a UV light dose from a second side opposite to the first side of the substrate.

2. A process according to claim 1 further comprising depositing a buffer layer (4) on top of said photoresist such that said vias are coated but not filled with said buffer layer.

3. The process of Claim 1, where the thick film paste comprises an acicular emitting substance.

4. The process of Claim 3 where the acicular emitting substance is carbon nanotubes.

5. The process of Claim 1 or Claim 2 wherein thick film is metered through openings in a coating edge then spread by the coating edge onto the substrate.

6. The process of Claim 1 or Claim 2 wherein thick film is metered from a container located in front of the coating edge and then spread by the coating edge onto the substrate.

7. The process of claim 1 or claim 2, wherein said thick film paste is spread across said vias in a direction parallel to the via side of greatest length.

8. The process of claim 1 or claim 2, wherein said coating edge comprises one or more wings for preventing paste run-off.

9. A process according to claim 1 further comprising developing the irradiated thick film paste with a developing solution by spraying and rinsing.

10. The process according to claim 1 wherein the substrate is coated with a conductive film.

## Patentansprüche

1. Verfahren, umfassend:
a) Auftragen eines Fotoresists auf eine erste Seite eines durchsichtigen Substrats;
b) Gestalten von Kontaktlöchern (3) im Fotoresist;
c) Aufbringen einer Ablagerung einer Dickfilmpaste auf das Fotoresist, mittels eines Beschichtungsrands;
d) Aufstreichen der Ablagerung der Dickfilmpaste auf die Oberfläche des Fotoresists mit einem Beschichtungsrand in direktem Kontakt mit der Deckfläche des Fotoresists, sodass die Dickfilmpaste die Kontaktlöcher ausfüllt; und
e) Bestrahlen der Dickfilmpaste durch das transparente Substrat mit einer UV-Licht-Dosis von einer zweiten Seite gegenüber der ersten Seite des Substrats.

2. Verfahren nach Anspruch 1, ferner umfassend das Ablagern einer Pufferschicht (4) auf der Oberseite des Fotoresists, sodass die Kontaktlöcher mit der Pufferschicht beschichtet, jedoch nicht gefüllt werden.

3. Verfahren nach Anspruch 1, wobei die Dickfilmpaste eine nadelförmige emittierende Substanz umfasst.

4. Verfahren nach Anspruch 3, wobei die nadelförmige emittierende Substanz Kohlenstoffnanoröhrchen sind.

5. Verfahren nach Anspruch 1 oder Anspruch 2, wobei der Dickfilm durch Öffnungen in einem Beschichtungsrand dosiert wird und dann vom Beschichtungsrand auf das Substrat aufgetragen wird.

6. Verfahren nach Anspruch 1 oder Anspruch 2, wobei der Dickfilm von einem Behälter, der sich vor dem Beschichtungsrand befindet, dosiert wird, und dann vom Beschichtungsrand auf dem Substrat verteilt wird.

7. Verfahren nach Anspruch 1 oder Anspruch 2, wobei die Dickfilmpaste quer durch die Kontaktlöcher in eine Richtung parallel zur längsten Kontaktlochseite verteilt wird.

8. Verfahren nach Anspruch 1 oder Anspruch 2, wobei der Beschichtungsrand einen oder mehrere Flügel umfasst, um ein Überlaufen der Paste zu verhindern.

9. Verfahren nach Anspruch 1, ferner umfassend das Entwickeln der bestrahlten Dickfilmpaste mit einer Entwicklungslösung durch Sprühen oder Spühlen.

10. Verfahren nach Anspruch 1, wobei das Substrat mit einem leitenden Film beschichtet ist.

## Revendications

1. Procédé comprenant:
a) appliquer une résine photosensible sur un premier côté d'un substrat transparent;
b) modeler des trous d'interconnexion (3) dans ladite résine photosensible ;
c) appliquer un dépôt de pâte de couche épaisse sur ladite résine photosensible, au moyen d'un bord de revêtement ;
d) répandre le dépôt de pâte de couche épaisse sur la surface de ladite résine photosensible avec un bord de revêtement en contact direct avec la surface supérieure de ladite résine photosensible de sorte que la pâte de couche épaisse remplisse les trous d'interconnexion ; et
e) irradier la pâte de couche épaisse à travers le substrat transparent avec une dose de lumière UV d'un deuxième côté opposé au premier côté du substrat.

2. Procédé selon la revendication 1, comprenant en outre le dépôt d'une couche tampon (4) sur le sommet de ladite résine photosensible de sorte que lesdits trous d'interconnexion sont revêtus mais pas remplis avec ladite couche de tampon.

3. Procédé selon la revendication 1, dans lequel la pâte de couche épaisse comprend une substance émettrice aciculaire.

4. Procédé selon la revendication 3, dans lequel la substance émettrice aciculaire sont des nanotubes de carbone.

5. Procédé selon la revendication 1 ou 2, dans lequel le film épais est dosé à travers des ouvertures dans un bord de revêtement puis répandu par le bord de revêtement sur le substrat.

6. Procédé selon la revendication 1 ou 2, dans lequel le film épais est dosé à partir d'un conteneur situé devant le bord de revêtement puis répandu par le bord de revêtement sur le substrat.

7. Procédé selon la revendication 1 ou 2, dans lequel ladite pâte de couche épaisse est répandue à travers lesdits trous d'interconnexion dans une direction parallèle au côté de trou d'interconnexion le plus long.

8. Procédé selon la revendication 1 ou 2, dans lequel ledit bord de revêtement comprend une ou plusieurs ailes pour empêcher que la pâte ne déborde.

9. Procédé selon la revendication 1, comprenant en outre le développement de la pâte de couche épaisse irradiée avec une solution de développement par pulvérisation et rinçage.

10. Procédé selon la revendication 1, dans lequel le substrat est revêtu d'un film conducteur.
